# FASCICULE DE BREVET EUROPEEN

(11) **EP 3 503 323 B1**
(45) Date de publication et mention de la délivrance du brevet: **15.04.2026**
(21) Numéro de dépôt: 18209547.1
(22) Date de dépôt: 30.11.2018
(51) Int. Cl.: H02G 3/12, H02G 3/08, H02G 3/18

(54) **SUPPORT D'APPAREILLAGE ÉLECTRIQUE RECEVANT UNE PLAQUETTE EN COULISSEMENT**
HALTERUNG FÜR ELEKTRISCHE GERÄTE, DIE MIT EINEM SCHIEBEPLÄTTCHEN AUSGESTATTET IST
ELECTRICAL SWITCHGEAR MOUNTING RECEIVING A SLIDING PLATE

(30) Priorité: 22.12.2017 FR 1763032
(43) Date de publication de la demande: 26.06.2019
(73) Titulaire: Legrand France, 87000 Limoges (FR); Legrand SNC, 87000 Limoges (FR)
(72) Inventeur: BAUDOU, Alain, 87000 Limoges (FR)
(74) Mandataire: Jacobacci & Partners France

(56) Documents cités:
- EP-A1- 0 928 052
- EP-A1- 1 675 235
- EP-A1- 2 790 282
- EP-A1- 2 966 741
- US-A- 3 770 872
- US-A- 4 019 647

## Description

### DOMAINE TECHNIQUE AUQUEL SE RAPPORTE L'INVENTION

La présente invention concerne de manière générale le domaine des appareillages électriques, et en particulier des supports d'appareillage électrique.

Elle concerne plus précisément un support d'appareillage électrique selon le préambule de la revendication 1.

L'invention concerne également un appareillage électrique comportant un support d'appareillage électrique tel que précité, et un mécanisme d'appareillage électrique monté sur ce support d'appareillage électrique.

L'invention trouve une application particulièrement intéressante dans la réalisation d'un bloc d'appareillages électriques multipostes à partir de supports d'appareillage électrique monopostes montés dans des boîtes électriques monopostes accolées.

### ARRIERE-PLAN TECHNOLOGIQUE

On connaît notamment des documents EP0928052 et EP2966741 un support d'appareillage électrique du type précité. Dans ce support d'appareillage électrique, les moyens de coulissement autorisent le déplacement de deux plaquettes en vis-à-vis l'une de l'autre, mais la mise en place du support d'appareillage électrique sur l'élément de réception est fastidieuse dans la mesure où il faut faire coïncider, simultanément et de manière individuelle, l'ouverture traversante de chaque plaquette avec l'emplacement correspondant prévu sur l'élément de réception pour recevoir les vis de fixation.

On connaît également un autre support d'appareillage électrique dans lequel les plaquettes sont montées mobiles en coulissement sur le corps, de manière imperdable. En plus de l'inconvénient précité, les plaquettes mobiles imperdables génèrent du bruit lors de la manipulation du support d'appareillage électrique, ce qui confère à ce dernier une image de moindre qualité.

### OBJET DE L'INVENTION

Afin de remédier aux inconvénients précités de l'état de la technique, la présente invention propose un support d'appareillage électrique dont la manipulation est non bruyante et le montage sur l'élément de réception facilité.

Plus particulièrement, on propose selon l'invention un support d'appareillage électrique selon la revendication 1.

Ainsi, grâce aux moyens de rappel élastique, la plaquette est maintenue en position de repos lorsque le support d'appareillage électrique n'est pas monté dans l'élément de réception. Tout en restant mobile, la plaquette n'est donc mise en mouvement que sous l'action d'une contrainte, ce qui réduit le bruit lors de la manipulation du support d'appareillage électrique.

En outre, tout en restant mobile, la plaquette présente une position fixe et prédéterminée sur le support d'appareillage électrique car, lorsque celui-ci est isolé de l'élément de réception, les moyens de rappel rappellent la plaquette dans la position de repos prédéterminée sur le corps. Cela facilite le montage et la fixation dudit support d'appareillage électrique sur l'élément de réception.

D'autres caractéristiques non limitatives et avantageuses du support d'appareillage électrique conforme à l'invention, prises individuellement ou selon toutes les combinaisons techniquement possibles, sont données dans les sous-revendications 2 à 11.

L'invention concerne également un appareillage électrique selon la revendication 12.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une vue schématique éclatée en perspective latérale d'un ensemble dans lequel un appareillage électrique selon l'invention est monté dans une boîte électrique au moyen de deux éléments de fixation, cet appareillage électrique comprenant un premier mode de réalisation d'un support d'appareillage électrique selon l'invention ;
- la figure 2 est une vue schématique éclatée en perspective avant du support d'appareillage électrique de la figure 1, isolé du reste de l'appareillage électrique ;
- la figure 3 est une vue schématique avant du support d'appareillage électrique de la figure 2 dont les différents éléments sont assemblés les uns aux autres ;
- la figure 4 est une vue schématique partielle du support d'appareillage électrique de la figure 2, représentant un logement de ce support ;
- les figures 5 et 6 sont respectivement des vues schématiques en perspective avant et arrière d'une des plaquettes du support d'appareillage électrique de la figure 2 ;
- la figure 7 est une vue schématique d'une des plaquettes du support en cours de montage sur la boîte électrique de la figure 1, la plaquette étant encore en position de repos sur ledit support ;
- les figures 8 et 9 sont des vues schématiques arrachées, en perspective latérale, d'une plaquette respectivement en cours d'assemblage et assemblée sur le corps du support de la figure 2 ;
- les figures 10 et 11 sont des vues schématiques avant du support de la figure 3 respectivement en cours de montage et monté sur la boîte électrique de la figure 1;
- la figure 12 est une vue schématique éclatée en perspective avant d'un bloc bi-poste dans lequel deux supports selon l'invention sont montés dans deux boîtes électriques monoposte accolées, et recouverts par une unique plaque de finition bi-poste (les mécanismes d'appareillage électrique ne sont pas représentés) ;
- les figures 13 et 14 sont des vues schématiques avant du bloc bi-poste de la figure 9, dans lesquelles la plaque de finition n'est pas représentée, les supports étant respectivement non jumelés et jumelés l'un à l'autre ;
- la figure 15 est une vue schématique en perspective latérale d'une plaquette assemblée sur le corps d'un support selon un deuxième mode de réalisation de l'invention ;
- les figures 16 et 17 sont des vues schématiques avant de la plaquette de la figure 12, respectivement en position de repos et en première position de montage sur ledit support ; et,
- les figures 18 et 19 sont des représentations schématiques en vue arrière d'une plaquette assemblée sur le corps d'un support selon un troisième mode de réalisation de l'invention, respectivement en position de repos et en première position de montage sur ledit corps.

En préliminaire, on notera que les éléments identiques ou similaires des différents modes de réalisation de l'invention ne seront pas décrits à chaque fois.

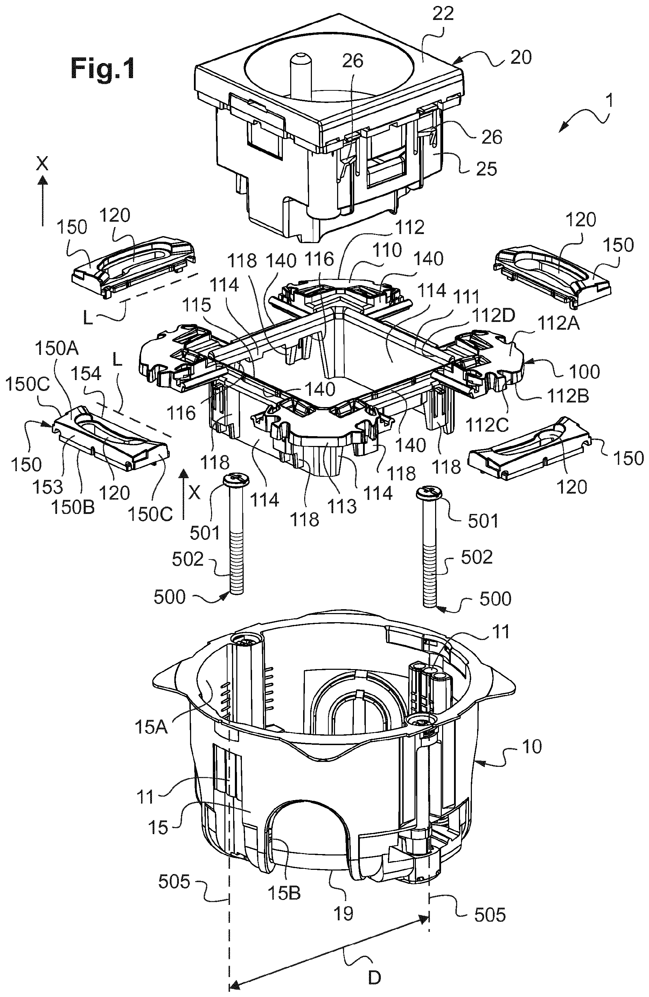

Sur la figure 1, on a représenté un ensemble comportant un premier mode de réalisation d'un appareillage électrique 1 selon l'invention et un élément de réception sur lequel l'appareillage électrique 1 est destiné à être monté et fixé.

Plus précisément, l'appareillage électrique 1 de l'ensemble de la figure 1 comporte un mécanisme d'appareillage électrique 20 et un premier mode de réalisation d'un support d'appareillage électrique 100 selon l'invention.

Ce premier mode de réalisation du support d'appareillage électrique 100 sera décrit ci-dessous en plus grands détails en référence aux figures 1 à 14.

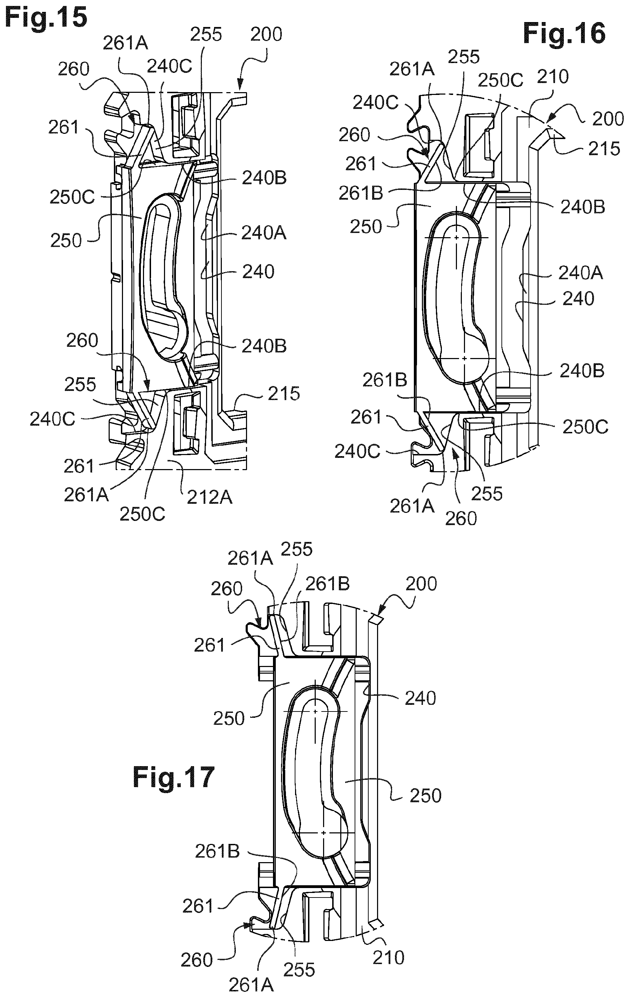

Un deuxième et un troisième mode de réalisation d'un support d'appareillage électrique 200 ; 300 selon l'invention sont représentés schématiquement respectivement sur les figures 15 à 17 et 18 à 19. Ces deuxième et troisième modes de réalisation du support d'appareillage électrique 200, 300 présentent des variantes structurelles du premier mode de réalisation du support d'appareillage électrique 100. Seules leurs différences par rapport au premier mode de réalisation seront explicitées plus loin dans la description.

Pour faciliter la lecture, dans la suite de la description, le support d'appareillage électrique 100 sera appelé support 100.

De manière générale, le mécanisme d'appareillage électrique 20 est adapté à être rapporté sur le support 100, qui est destiné à être monté et fixé, via deux éléments de fixation, dans l'élément de réception.

Le mécanisme d'appareillage électrique 20 est ici un mécanisme d'une prise de courant. En variante, le support 100 pourrait bien entendu recevoir d'autres mécanismes d'appareillage électrique tels qu'un mécanisme d'interrupteur, d'une prise USB, d'une prise de téléphone, d'une prise TV, ou encore d'une prise Ethernet, par exemple.

Ce mécanisme d'appareillage électrique 20 comprend de manière générale un socle 25 en matériau isolant, logeant les composants électriques du mécanisme d'appareillage électrique 20 et un enjoliveur 22 donnant la fonction électrique au mécanisme. Ici, l'enjoliveur 22 comporte un puits de réception pour accueillir une fiche électrique. En variante, l'enjoliveur peut comporter une ou plusieurs touches d'interrupteur ou un puits de réception d'un connecteur de téléphone ou USB par exemple.

Ici, l'élément de réception est une boîte électrique 10. Cette boîte électrique 10 est une boîte d'encastrement à accrocher dans un orifice d'encastrement d'une cloison creuse. En variante, la boîte électrique pourrait également être du type à sceller dans une paroi maçonnée ou à fixer en saillie d'une paroi.

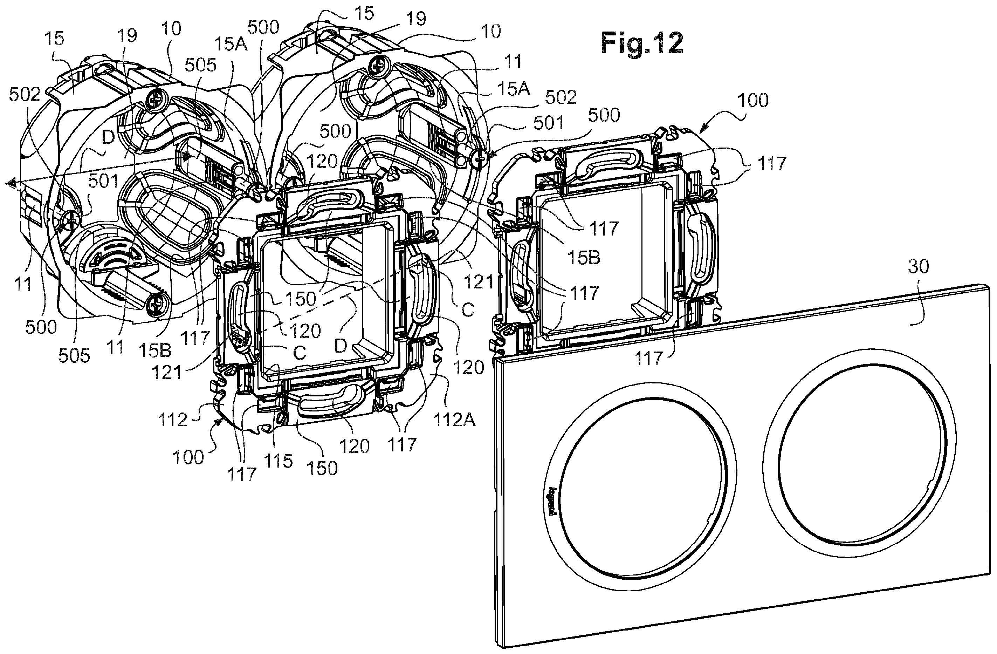

Comme le montre les figures 1 et 12, cette boîte électrique 10 comporte une paroi latérale 15 qui est fermée à l'arrière par une paroi de fond 19 et qui délimite à l'avant une ouverture de réception du mécanisme d'appareillage électrique 20. La paroi latérale 15 de la boîte électrique 10 porte intérieurement, sur une face interne 15A, deux fûts de vissage 11 dans chacun desquels est vissée une vis de fixation 500 constituant l'un des éléments de fixation.

Ici, cette boîte électrique 10 présente une forme cylindrique, mais elle pourrait présenter une forme différente, notamment parallélépipédique.

Telle que représentée sur les figures 1 et 12, la boîte électrique 10 présente dans sa paroi latérale 15 et dans sa paroi de fond 19 des ouvertures 15B de passage de gaine de cheminement (dans lesquelles peuvent être insérés des fils électriques, des fibres optiques, ...), qui sont initialement obturées par des opercules défonçables.

Cette boîte électrique 10 est prévue pour être rapportée dans une paroi murale, de telle manière que son ouverture avant affleure la face avant de la paroi murale et que les axes de fixation 505 des deux vis de fixation 500 se retrouvent dans un même plan, globalement horizontal.

Dans la description, les termes « avant » et « arrière » seront alors utilisés par rapport à la direction du regard de l'utilisateur tourné vers l'appareillage électrique monté dans la paroi. Ainsi, l'avant d'un élément désignera le côté de cet élément qui est tourné vers l'utilisateur et l'arrière désignera le côté opposé.

Tel que représenté sur la figure 1, le support 100 comporte un corps 110 en matériau isolant formant un cadre 112 prolongé vers l'arrière par quatre parois tombantes 114.

Ici, le corps 110 du support 100 est moulé dans une matière plastique.

Plus précisément, comme le montre la figure 1, le cadre 112 du corps 110 est globalement plat. Il présente ici une forme carré, avec quatre branches. Il comporte une face avant 112A et une face arrière 112B reliées entre elles par une tranche externe 112C et une tranche interne 112D. Les tranches externe et interne 112C, 112D forment respectivement un bord périphérique externe 113 et un bord périphérique interne 111 du cadre 112 du corps 110.

Le cadre 112 du corps 110 s'étend globalement dans un plan moyen.

Le bord périphérique interne 111 du cadre 112 délimite une ouverture d'accueil 115 d'un ou plusieurs mécanismes d'appareillage électrique 20 tels que décrits précédemment. L'ouverture d'accueil 115 est globalement comprise dans le plan moyen dans lequel s'étend le cadre 112.

Ici, l'ouverture d'accueil 115 peut accueillir un socle de largeur « 2 modules » de mécanisme d'appareillage électrique ou deux socles de largeur « 1 module » de mécanismes d'appareillage électrique. Dans l'exemple représenté sur la figure 1, l'ouverture d'accueil 115 accueille le socle 25 de largeur « 2 modules » du seul mécanisme d'appareillage électrique 20.

Cette ouverture d'accueil 115 présente ici, comme le cadre 112, une forme carrée et autorise le passage du socle 25 du mécanisme d'appareillage électrique 20.

Comme le montre la figure 1, les quatre parois tombantes 114 du corps 110 s'étendent à partir de la face arrière 112B du cadre 112 et bordent l'ouverture d'accueil 115. Leurs faces internes, tournées vers l'ouverture d'accueil 115, prolongent le bord périphérique interne 111 du cadre 112. Ces parois tombantes 114 s'étendent sensiblement perpendiculairement au plan moyen du cadre 112.

Plus précisément, ces parois tombantes 114 délimitent un puits de réception du support 100 adapté à accueillir le socle 25 du mécanisme d'appareillage électrique 20. Le socle 25 et le puits de réception du support 100 sont de forme complémentaire, ici globalement parallélépipédique, de sorte que lorsque le socle 25 du mécanisme d'appareillage électrique 20 est emboîté dans ce puits de réception, l'enjoliveur 22 du mécanisme d'appareillage électrique 20 ferme l'ouverture d'accueil 115 du support 100.

Pour le montage du socle 25 du mécanisme d'appareillage électrique 20 sur le support 100, ce support 100 comporte des moyens de montage destinés à coopérer avec des moyens de montage complémentaires portés par le socle 25 du mécanisme d'appareillage électrique 20.

Les moyens de montage sont prévus à proximité du bord périphérique interne 111 du cadre 112 délimitant ladite ouverture d'accueil 115. Ici, les moyens de montage sont plus précisément prévus dans deux parois tombantes 114 opposées. Ces moyens de montage sont des moyens d'encliquetage.

Comme le montre la figure 1, les deux parois tombantes 114 opposées portant les moyens de montage sont évidées et le bord libre de ces deux parois tombantes 114 opposées comporte des encoches d'encliquetage 116 dont les tranches forment des rebords d'accrochage sur lesquels sont adaptées à s'accrocher des dents d'encliquetage 26 faisant saillie de deux faces latérales opposées du socle 25.

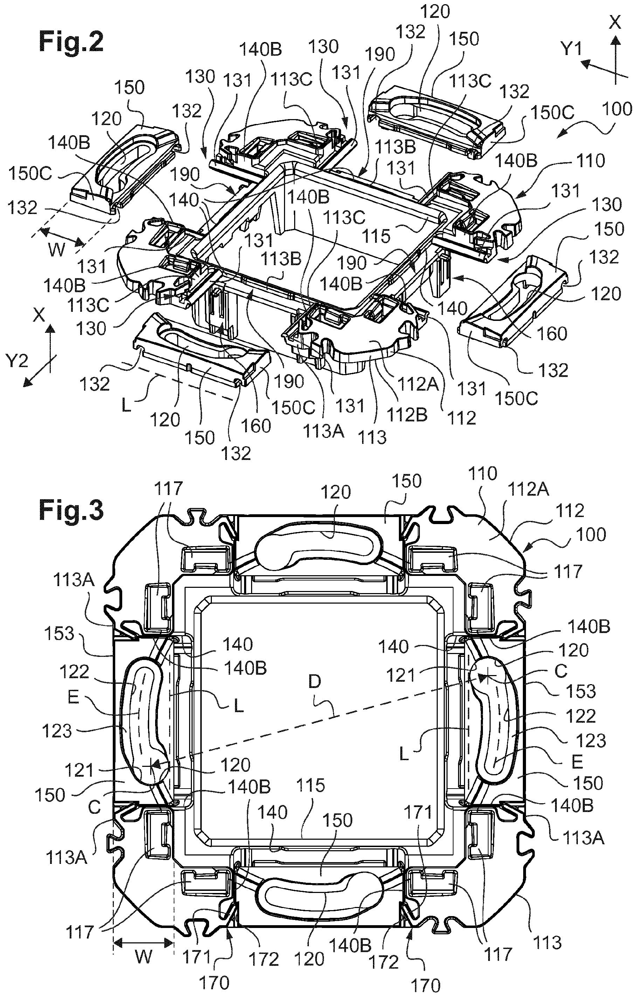

Par ailleurs, comme le montrent mieux les figures 3 et 12, il est prévu sur le cadre 112 du corps 110 du support 100 des moyens d'assemblage 117 d'une plaque de finition 30 (figure 12). Ces moyens d'assemblage 117 sont accessibles en face avant 112A dudit cadre 112. Il comprennent ici des moyens d'encliquetage, notamment une pluralité de logements muni chacun d'une dent d'accrochage adaptée à coopérer à retenue avec des moyens d'accrochage complémentaire prévus en face arrière de la plaque de finition 30.

Tel que cela est représenté sur les figures 1 et 12, le support 100 est monté et fixé sur la boîte électrique 10 au moyen des deux vis de fixation 500 reçues dans les fûts de vissage 11 filetés prévus de manière diamétralement opposée sur la face interne 15A de la paroi latérale 15 de la boîte électrique 10.

A cet effet, comme le montrent en particulier les figures 3, 10, 11 et 12, le support 100 présente au moins deux ouvertures traversantes 120 diamétralement opposées, de part et d'autre de l'ouverture d'accueil 115, pour le passage des vis de fixation 500.

Il est ici prévu quatre ouvertures traversantes 120 disposées chacune globalement au centre de l'une des quatre branches du cadre 112 du support 100.

Plus précisément, comme le montrent les figures 3, 7 et 10, chaque ouverture traversante 120 présente ici une forme globalement allongée et s'étend selon une direction longitudinale L. Ici, pour chaque ouverture traversante 120, la direction longitudinale L est parallèle à la branche du cadre 112 dans laquelle est disposée ladite ouverture traversante 120.

Comme le montrent plus particulièrement les figures 3, 7, 10 et 11 chaque ouverture traversante 120 présente ici une forme en trou de serrure, c'est-à-dire présentant une majeure partie allongée 122, à l'extrémité de laquelle il est prévu une partie circulaire 121.

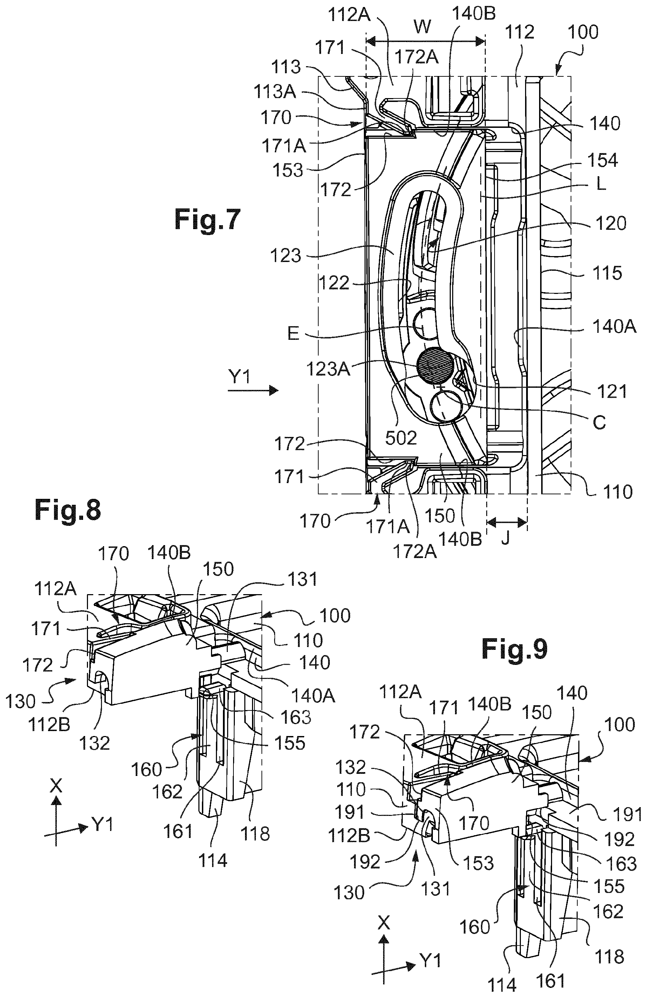

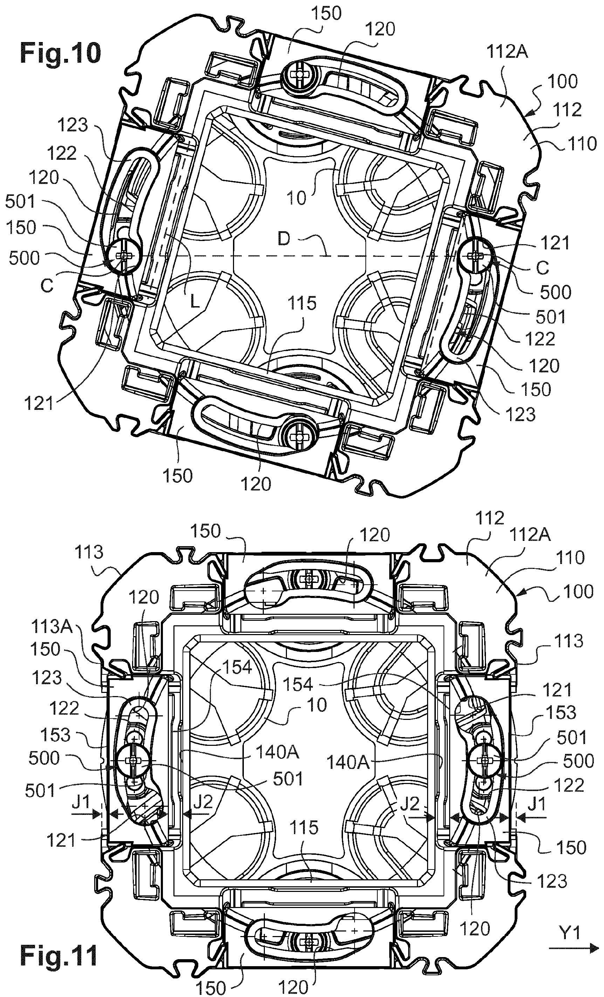

En particulier, chaque partie circulaire 121 autorise le passage de la tête de vis 501 (figure 10), et la partie allongée constitue un trou oblong 122 prolongeant ladite partie circulaire 121. La largeur du trou oblong 122 est inférieure au diamètre de la partie circulaire 121 pour autoriser le passage du corps de vis 502 seulement (figures 7 et 11).

Ici, comme le montent les figures 3, 7, 10 et 11, le trou oblong 122 est délimité par un trottoir 123 s'étendant en retrait par rapport à la face avant 112A du cadre 112 du corps 110 du support 100 pour recevoir, en appui, la tête de vis 501 (figure 11). Ainsi, lorsque le support 100 est fixé sur la boîte électrique 10 par le serrage de la vis de fixation 500, la face avant de ladite tête de vis 501 affleure la face avant 112A du cadre 112 du support 100 (figure 11).

Tel que représenté sur les figures 3 et 7, le trou oblong 122 de l'ouverture traversante 120 s'étend selon un grand axe E courbé, dont la concavité est tournée vers l'ouverture d'accueil 115 du support 100. Grâce à la courbure de du grand axe E du trou oblong 122, le support 100 peut être pivoté angulairement par le coulissement conjoint de chaque corps de vis 502 dans le trou oblong 122 correspondant, ce qui permet un rattrapage angulaire dudit support 100 lors de sa fixation sur la boîte électrique 10.

Comme le montrent plus précisément les figures 1 et 2, chaque ouverture traversante 120 du support 100 est ici formée dans une plaquette 150 rapportée sur le corps 110 du support 100. Ainsi, le support 100 comporte, dans cet exemple, au moins deux plaquettes 150 rapportées sur le corps 110, en vis-à-vis par rapport à l'ouverture d'accueil 115.

Comme le montrent les figures 1 à 3 et 10 à 12, le support 100 comporte ici plus particulièrement quatre plaquettes 150 disposées deux à deux en vis-à-vis sur le corps 110. Ainsi, le montage du support 100 sur la boîte électrique 10 peut être réalisé pour différentes orientations du mécanisme d'appareillage électrique 20. Ici, le montage du support 100 sur la boîte électrique 10 n'impose pas d'orientation à la prise de courant par rapport à la verticale ou à l'horizontale de la paroi d'installation.

Les plaquettes 150 forment des pièces séparées du corps 110 du support 100 de sorte que ledit corps 110 du support 100 et les plaquettes 150 peuvent être réalisés dans des matériaux distincts.

Ici, chaque plaquette 150 est moulée en un matériau polymère rigide, par exemple un matériau polymère chargé en fibres de verre ou un ABC (Acrylonitrile Butadiène Styrène), tandis que le corps 110 du support 100 est moulé en un matériau polymère isolant moins couteux. En variante, les plaquettes pourraient être réalisées en métal. On pourrait aussi prévoir de mouler les plaquettes 150 dans un matériau polymère d'une première couleur et le corps du support dans un matériau polymère d'une deuxième couleur.

Comme le montrent les figures 1, 2, 5, et 6, chaque plaquette 150 présente, dans cet exemple, une forme globalement parallélépipédique aplatie, allongée selon la direction longitudinale L de l'ouverture traversante 120. Telle que représentée plus précisément sur les figures 1, 5 et 6, chaque plaquette 150 comporte deux faces principales opposées, à savoir une face avant 150A et une face arrière 150B, reliées entre elles par quatre bords latéraux 150C, 153, 154 constituant la tranche de la plaquette 150. Le bord interne 154 de la tranche de la plaquette 150 est destiné à être tourné vers l'ouverture d'accueil 115 du support 100, tandis que le bord externe 153 de la tranche de la plaquette 150, opposé audit bord interne 154 est destiné à être tourné vers l'extérieur du support 100. Les bords d'extrémité 150C de la tranche de la plaquette 150 relient lesdits bords interne et externe 154, 153. L'ouverture traversante 120 de chaque plaquette 150 traverse ladite plaquette 150 de part en part et débouche à la fois sur la face avant 150A et sur la face arrière 150B de ladite plaquette 150.

Pour recevoir les plaquettes 150, le support 100 est muni de moyens d'assemblage du corps 110 du support 100 et de la plaquette 150.

Plus précisément, comme le montrent les figures 2, 8 et 9, les moyens d'assemblage comportent des moyens de coulissement réciproques entre le corps 110 et la plaquette 150. Ces moyens de coulissement réciproques comportent plus particulièrement des moyens de coulissement 130 appartenant au corps 110 du support 100, ainsi que des moyens de coulissement complémentaires appartenant à chaque plaquette 150. Bien entendu, les moyens de coulissement 130 du corps 110 du support 100 sont adaptés à coopérer avec les moyens de coulissement complémentaires de chaque plaquette 150.

De manière remarquable, comme le montrent les figures 2, 4, 8 et 9, il est prévu selon l'invention que le corps 110 du support 100 comporte un logement 140 pour accueillir chaque plaquette 150, lesdits moyens de coulissement 130 étant au moins partiellement ménagés dans chaque logement 140, et que le support 100 comporte en outre des moyens de rappel élastique 160 intervenant entre chaque plaquette 150 et ledit corps 110 du support 100 pour rappeler chaque plaquette 150 dans une position de repos prédéterminée.

Plus précisément, comme le montrent les figures 1 et 2, le corps 110 comporte ici quatre logements 140, chacun adapté à accueillir une des plaquettes 150.

Comme le montrent les figures 1, 2 et 4, chaque logement 140 comporte une partie traversante débouchant, d'un côté, sur la face avant 112A dudit cadre 112, et, de l'autre côté, sur la face arrière 112B de ce cadre 112. Cette partie traversante coïncide au moins partiellement avec l'ouverture traversante 120 de la plaquette 150 reçue dans ledit logement 140 pour permettre le passage de chaque vis de fixation 500 dans la boîte électrique 10.

Dans le premier mode de réalisation représenté sur les figures 1 à 14, comme le montrent plus particulièrement les figures 1, 2, 4, 8 et 9, chaque logement 140 est ici quasi-intégralement ouvert selon une direction X sensiblement perpendiculaire à la face avant 112A du cadre 112 du corps 110 et au plan moyen dans lequel s'étend le cadre 112. Autrement dit, dans le plan moyen dans lequel s'étend le cadre 112, la surface du logement est très majoritairement occupée par la partie traversante de ce logement.

Chaque logement 140 est ménagé en renfoncement dans ledit corps 110 et plus particulièrement en renfoncement dans le cadre 112 du corps 110.

Plus précisément, comme le montre la figure 2, dans le premier mode de réalisation du support 100, chaque logement 140 est formé par un renfoncement dans le cadre 112, ledit renfoncement étant délimité par le bord périphérique externe 113 dudit cadre 112. Ainsi, chaque logement 140 s'ouvre vers l'extérieur du support 100 et forme ici une découpe dans la branche correspondante du cadre 112.

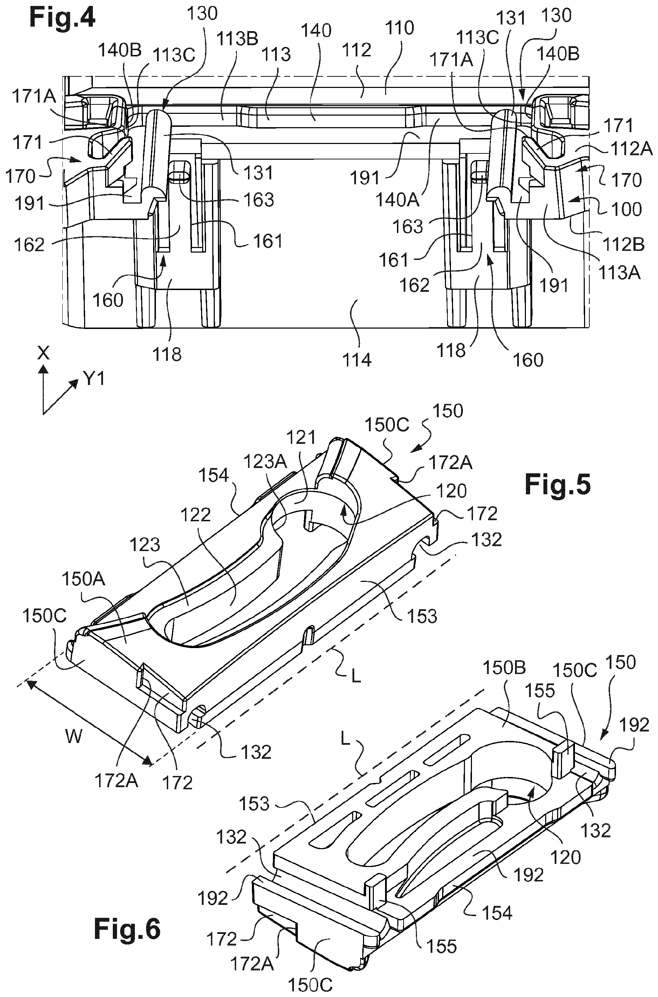

Comme le montre bien les figures 2 et 4, dans chaque branche, le bord périphérique externe 113 du cadre 112 du corps 110 comporte alors une première portion 113A à partir de laquelle est formé le renfoncement, une deuxième portion 113B qui s'étend en retrait par rapport à ladite première portion, à distance et globalement parallèlement à ladite première portion 113A, et deux autres portions 113C qui relient, globalement perpendiculairement, lesdites première et deuxième portions 113A, 113B.

Ainsi, comme le montre bien la figure 4, chaque logement 140 est globalement de forme rectangulaire et présente trois côtés fermés et un quatrième côté ouvert. Plus précisément, le logement 140 présente, d'une part, deux bords latéraux 140B opposés, formés par lesdites autres portions 113C du bord périphérique externe 113, et d'autre part, un fond 140A reliant lesdits bords latéraux 140B, ce fond 140A étant formé par la deuxième portion 113B du bord périphérique externe 113. L'entrée du logement 140 est délimitée entre lesdits bords latéraux 140B opposés, à l'opposé dudit fond 140A, c'est-à-dire entre les deux premières portions 113A du bord périphérique externe 113. Le fait que le logement 140 soit ouvert sur son quatrième côté, vers l'extérieur du support 100, facilite l'assemblage de la plaquette 150 dans le logement 140.

Comme le montrent les figures 2, 3 et 7, chaque logement 140 présente une forme globalement complémentaire de la forme de chaque plaquette 150, à ceci près que les bords latéraux 140B opposés dudit logement 140 s'étendent sur une distance plus longue que les bords d'extrémité 150C de la plaquette 150 formant « la largeur W » de la plaquette 150.

Les moyens de coulissement 130 prévus sur le corps 110 du support 100, dans chaque logement 140, sont adaptés à recevoir la plaquette 150 mobile en coulissement. Autrement dit, les moyens de coulissement 130 du corps 110 reçoivent la plaquette 150 en coulissement pour l'assemblage de ladite plaquette 150 sur le corps 110 du support 100, et une fois la plaquette 150 assemblée sur le corps 100, les moyens de coulissement 130 autorisent encore le coulissement de ladite plaquette 150 à l'intérieur du logement 140.

Comme le montrent bien les figures 2 et 4, les moyens de coulissement 130 du corps 110 sont portés par les bords latéraux 140B opposés de chaque logement 140. Ils s'étendent à l'intérieur du logement 140, le long de chaque bord latéral 140B du logement 140.

Ici, comme le montrent les figures 2, 4, 8 et 9, les moyens de coulissement 130 dans chaque logement 140 comprennent deux coulisseaux de guidage 131 qui s'élèvent en saillie vers l'avant à partir d'un trottoir d'appui 191 de faible largeur (bien visible sur la figure 4) prévu le long de chaque bord latéral 140B opposé du logement, à proximité de la face arrière 112B du cadre 112.

Ici, comme le montre bien la figure 4, l'extrémité libre de chaque coulisseau de guidage 131 présente une forme en quart de cylindre. Grâce à la forme particulière de l'extrémité libre de chaque coulisseau de guidage 131, les moyens de coulissement 130 présentent un effet de solidarisation de la plaquette 150 sur le corps 110. Autrement dit, les moyens de coulissement 130 permettent de retenir la plaquette 150 sur le corps 110, selon la direction X.

Comme le montrent bien les figures 2, 5 et 6, chaque plaquette 150 porte quant à elle, le long de ces deux bords d'extrémité 150C, une coulisse 132 adaptée à coopérer avec lesdits coulisseaux de guidage 131 du logement 140. Chaque coulisse 132 s'étend à proximité de chaque bord d'extrémité 150C de la plaquette 150, parallèlement à ce bord d'extrémité 150C. Chaque coulisse 132 est ici ménagée en creux dans la face arrière 150B de ladite plaquette 150. Elle débouche à la fois sur la face arrière 150B, le bord interne 154 (qui est tourné vers le fond 140A du logement 140) et le bord externe 153 de la tranche de ladite plaquette 150.

Ainsi, lesdits moyens de coulissement 130 autorisent un mouvement de translation relatif de ladite plaquette 150 par rapport au cadre 112 du support 100, selon une direction de coulissement Y1, Y2 globalement perpendiculaire à la direction longitudinale L de l'ouverture traversante 120 de la plaquette 150 (figure 2). Cet agencement offre un degré de liberté supplémentaire pour agencer le support 100 sur la boîte électrique 10.

Comme le montrent les figures 2, 4, 8 et 9, dans le premier mode de réalisation du support 100, les moyens de rappel élastique 160 sont portés par le corps 110 du support 100 et prennent appui sur une surface d'appui 155 de ladite plaquette 150 (surface d'appui 155 bien visible sur les figures 6, 8 et 9).

Plus précisément, les moyens de rappel élastique 160 s'étendent à proximité de ou dans chaque logement 140.

Ici, les moyens de rappel élastique 160 viennent de formation avec le corps 110 du support 100. Ils sont donc moulés en matière plastique, comme le corps 110. Leur propriété de « rappel » leur est notamment conférée par le matériau utilisé pour leur fabrication, leur forme, leur épaisseur et leur raideur.

En particulier, comme le montrent les figures 4, 8 et 9, les moyens de rappel élastique 160 comportent ici deux lames ressort 161 adaptées à agir sur chaque plaquette 150. Chaque lame ressort 161 est découpée dans un montant 118 situé le long de la paroi tombante 114 correspondante du corps 110 du support 100. Les montants 118 sont bien visibles sur la figure 1 et s'étendent chacun selon la direction X, à l'extérieur de chaque paroi tombante 114.

Telle que représentée sur les figures 4, 8 et 9, chaque lame ressort 161 s'étend principalement selon la direction X, à l'arrière de la face arrière 112B du cadre 112, dans une région située globalement au droit de chaque coulisseau de guidage 131 ménagé dans le logement 140. Chaque lame ressort 161 comporte une jambe 162 découpée dans le montant 118 et terminée à l'avant par une extrémité libre formant un pied 163 adapté à prendre appui sur la surface d'appui 155 de la plaquette 150. L'extrémité arrière de la jambe 162 s'étend à proximité du bord libre du montant 118 dans lequel la lame ressort 161 est découpée.

Chaque lame ressort 161 est ainsi déformable selon la direction de coulissement Y1, Y2 associée au logement 140 dans lequel est logée la plaquette 150 avec laquelle elle interagit.

Pour empêcher le désassemblage involontaire de la plaquette 150 et du corps 110, malgré l'action des lames ressort 161, les moyens d'assemblage du support 100 comportent en outre ici des moyens de blocage 170 réciproques entre le corps 110 du support 100 et la plaquette 150. Les moyens de blocage 170 sont interposés entre le corps 110 du support 100 et la plaquette 150 pour empêcher ladite plaquette 150 de sortir du logement 140.

Plus précisément, comme le montrent les figures 3, 7, 8 et 9, les moyens de blocage 170 comportent des moyens de blocage externes du corps 110 adaptés à coopérer avec des moyens de blocage complémentaires de la plaquette 150.

En particulier, comme le montrent bien les figures 3, 4, 7, 8 et 9, ici, les moyens de blocage externe du corps 110 comportent une patte flexible 171 découpée dans chacun des bords latéraux 140B opposés de chaque logement 140, de part et d'autre de l'entrée dans chaque logement 140. Chaque patte flexible 171 fait légèrement saillie vers l'intérieur du logement 140, dans une région avant du support 100.

Comme le montrent bien les figures 3, 5, 6, 7, 8 et 9 les moyens de blocage complémentaires de chaque plaquette 150 comportent quant à eux une encoche 172 découpée sur chaque bord d'extrémité 150C de la tranche de ladite plaquette 150. Chaque encoche 172 débouche dans une région avant et externe seulement de ce bord d'extrémité 150C, d'une part, sur la face avant 150A de la plaquette 150, et, d'autre part, sur le bord externe 153 de ladite plaquette 150.

Comme le montrent les figures 8 et 9, pour insérer la plaquette 150 dans son logement 140, il suffit de faire coïncider chaque coulisseau de guidage 131 du logement 140 avec la coulisse 132 correspondante de la plaquette 150, depuis l'entrée du logement 140, et de pousser la plaquette 150 en direction du fond 140A du logement 140. Ce faisant, les deux pattes flexibles 171 disposées à l'entrée du logement 140, en regard l'une de l'autre, sont repoussées par les bords d'extrémité 150C de ladite plaquette 150, en direction bord latéral 140B du logement 140 à partir de laquelle chacune de ces pattes flexibles s'étend. Une fois la plaquette 150 suffisamment enfoncée dans le logement 140, chaque patte flexible 171 reprend sa position initiale et s'emboîte dans l'encoche 172 de la plaquette 150 prévue à cet effet, en général avec un « clic » sonore qui indique à l'installateur l'insertion correcte de la plaquette 150 sur le corps 110.

Comme le montrent la figure 7, le blocage de la plaquette 150 sur le corps 110 est opéré par l'extrémité libre 171A de la patte flexible 171 du corps 110 (figure 4) qui bute contre le fond 172A de l'encoche 172 de chaque plaquette 150 (figures 5 et 6). Une fois la plaquette 150 assemblée sur le corps 110 du support 100, sa face avant 150A affleure la face avant 112A du cadre 112.

Lorsque la plaquette 150 est assemblée sur le corps 110, la largeur du logement 140, supérieure à la largeur W de la plaquette 150, et lesdits moyens de coulissement 130 autorisent un mouvement de translation de ladite plaquette selon la direction de coulissement Y1, Y2 transverse à la branche correspondante du corps 110. D'une manière générale, on entend ici par « direction transverse » une direction qui s'étend entre le bord périphérique externe 113 du cadre 112 et l'ouverture d'accueil 115, globalement perpendiculairement à la partie du bord périphérique interne 111 la plus proche du logement 140.

Autrement dit, chaque plaquette 150 assemblée sur le corps 110 du support 100 peut être déplacée selon la direction de coulissement Y1, Y2 propre à chaque logement 140 (figure 2), entre le fond 140A du logement 140 et la première portion 113A du bord périphérique externe 113 du cadre 112. Cette direction de coulissement Y1, Y2 s'étend sensiblement perpendiculairement à la branche du cadre 112 dans laquelle est ménagé le logement 140 correspondant et donc perpendiculairement aux première et deuxième portions 113A, 113B du bord périphérique externe 113 correspondant.

Comme le montre la figure 9, lorsque la plaquette 150 est assemblée dans le logement 140 du support 100, en position de repos dans ce logement 140, le pied 163 de chaque lame ressort 161 de ce logement 140 est au contact de la surface d'appui 155 correspondante de la plaquette 150, et la lame ressort 161 est elle-même en position de repos.

Ici, comme le montrent les figures 3 et 7, lorsque la plaquette 150 est en positon de repos, le bord externe 153 de ladite plaquette 150, orienté vers l'extérieur du support 100, prolonge le bord périphérique externe 113 dudit cadre 112, au débouché du logement 140. Autrement dit, le bord externe 153 de la plaquette 150, en position de repos sur le corps 110, prolonge la portion du bord périphérique externe 113 du cadre 112 qui s'étend de part et d'autre du logement 140. En d'autres termes, selon le mode de réalisation représenté sur les figures 1 à 14, en position de repos, la plaquette 150 est dans une position extrême externe, poussée au maximum vers l'extérieur du support 100, de sorte que le bord externe 153 de la plaquette 150 s'étend globalement dans l'alignement de la première portion 113A du bord périphérique 113 de la branche correspondante du cadre 112 du support 100. Ici, le bord externe 153 de la plaquette 150 prolonge la première portion 113A du bord périphérique externe 113 du cadre 112. Ainsi, en position de repos, le bord externe 153 de la plaquette 150 s'étend dans le même plan que la première portion 113A du bord périphérique externe 113 de la branche correspondante du cadre 112, de manière rectiligne.

Dans cette position de repos, l'extrémité libre 171A de la patte flexible 171 des moyens de blocage 170 est en butée contre le fond 172A de l'encoche 172 de la plaquette 150.

Lorsque la plaquette est en position de repos, il existe alors un jeu J (figure 7) de l'ordre de quelques millimètres, par exemple égal à 2 millimètres, entre le bord interne 154 de ladite plaquette 150, opposé audit bord externe 153 de la plaquette 150, et le fond 140A du logement 140. Ce jeu J correspond à la course totale de coulissement possible de la plaquette 150 dans son logement 140, selon la direction de coulissement Y1, Y2 associée au logement 140.

Depuis sa position de repos, la plaquette 150 peut ainsi être poussée vers l'intérieur du support 100, c'est-à-dire vers le fond 140A du logement 140, au maximum jusqu'à une position extrême interne dans laquelle le bord interne 154 de la plaquette 150 entre en contact avec ledit fond 140A du logement 140. Lors de ce déplacement de la plaquette 150, les surfaces d'appui 155 de la plaquette 150 exercent une pression sur le pied 163 de chaque lame ressort 161, ce qui a pour effet de contraindre chaque lame ressort 161 en dehors de sa position de repos. Les lames ressorts 161 tendent alors à revenir à leur position d'équilibre et exercent ce faisant, via leur pied 163, une force de poussée contre la plaquette 150 pour la ramener dans sa position de repos.

Avantageusement, les moyens de blocage réciproques 170 du corps 110 du support 100 et de la plaquette 150 forment ensemble une butée de positionnement pour la plaquette 150 repoussée en position de repos, de sorte que ladite plaquette 150 ne peut pas être repoussée vers l'extérieur du corps 110 du support 100 au-delà de cette butée.

Ainsi, lorsque le support 100 est isolé de la boîte électrique 10, les plaquettes 150 du support 100 sont maintenues en position de repos.

Comme le montrent les figures 3 et 10, deux plaquettes 150 en vis-à-vis et en position de repos dans leur logement 140 respectifs sont telles que les centres C des parties circulaires 121 de leurs ouvertures traversantes 120 sont distants l'un de l'autre d'une distance prédéterminée égale à l'entraxe D séparant les deux fûts de vissage 11 des vis de fixation 500 dans la boîte électrique 10 (figures 1, 10 et 12). Ici l'entraxe D est égal à 60 millimètres.

Ainsi, grâce à l'invention, le montage du support 100 sur la boîte électrique 10 est facilité puisque les plaquettes 150 maintenues dans leur position de repos respective lorsque le support 100 est isolé de la boîte électrique 10, sont alors automatiquement distantes d'un espacement égal à celui séparant les axes de fixation 505 des vis de fixation 500 déjà montées sur la boîte électrique 10.

Comme le montrent les figures 10 et 11, pour monter le support 100 sur la boîte électrique 10, un utilisateur pivote légèrement ledit support 100 de manière à amener les parties circulaires 121 de deux plaquettes 150 en face des vis de fixation 500 préalablement vissées sur la boîte électrique 10 (figure 10). Une fois la tête de vis 501 de chaque vis de fixation 500 insérée dans la partie circulaire 121 de l'ouverture traversante 120 correspondante du support 100, l'utilisateur fait pivoter le support 100 en faisant coulisser le corps de vis 502 de chaque vis de fixation 500 dans le trou oblong 122 correspondant (figure 11). Ce pivotement a pour but de redresser le support 100, généralement jusqu'à ce que deux branches opposées du cadre 112 s'étendent sensiblement parallèlement à la droite passant par les centres des têtes des vis de fixation 500.

De manière avantageuse, comme le montre la figure 7, le centre C de la partie circulaire 121 de chaque plaquette 150 est ici décalé du grand axe E du trou oblong 122 de ladite plaquette 150 d'une distance inférieure ou égale au jeu J, c'est-à-dire inférieure à la course totale de coulissement de ladite plaquette 150 dans son logement 140. Plus précisément, le centre C de chaque partie ciruclaire 121 est ici décalé du grand axe E vers l'intérieur, d'une distance égale à la moitié du jeu J, soit de 1 millimètre dans cet exemple.

Du fait du décalage entre la partie circulaire 121 et le grand axe E du trou oblong 122, lorsque le support 100 est pivoté sur la boîte électrique 10, chaque plaquette 150 est forcée d'adopter une première position de montage dans son logement 140 (figure 11). La première position de montage de la plaquette 150 dans son logement 140 est ici définie comme une position intermédiaire de la plaquette 150, entre la position extrême externe et la position extrême interne. Les grands axes E du trou oblong 122 de l'ouverture traversante 120 de deux plaquettes 150 en vis-à-vis, en première position de montage sur le corps 110 du support 100, sont alors distants (diamétralement) de l'entraxe D, égal à 60 millimètres dans cet exemple.

Comme le montrent bien les figures 5 et 7, le trottoir 123 délimitant le trou oblong 122 présente ici un décroché 123A, à la jonction avec la partie circulaire 121, qui facilite le guidage du corps de vis 502 depuis la partie circulaire 121 vers le trou oblong 122.

Lorsque la plaquette 150 est dans la première position de montage (figure 11), il existe un premier jeu J1 entre le bord externe 153 de ladite plaquette 150 et la portion du bord périphérique externe 113 dudit cadre 112 qui s'étend de part et d'autre du logement 140, et un deuxième jeu J2 entre le bord interne 154 de ladite plaquette 150 et le fond 140A du logement 140. Ici, la première position de montage est une position centrale de la plaquette 150 dans son logement 140, de sorte que le premier jeu J1 est égal au deuxième jeu J2, ici égal à 1 millimètre. Tant que la vis de fixation 500 n'est pas serrée dans la boîte électrique 10, l'installateur peut déplacer, ici selon la direction de coulissement Y1, dans les deux sens de coulissement, le corps 110 du support 100 par rapport aux plaquettes 150 recevant les vis de fixation 500. Tel que représenté sur la figure 11, le corps 110 du support 100 peut être déplacé vers la droite ou vers la gauche de 1 millimètre à partir de la première position de montage qui est ici centrale.

Pour fixer le support 100 sur la boîte électrique 10, chaque vis de fixation 500 est ensuite vissée au maximum dans le fût de vissage 11 correspondant de la boîte électrique 10.

Par cette opération de vissage, la plaquette 150 est serrée contre le support 100, lui-même alors plaqué contre la face avant de la paroi d'installation par un effet de bride.

Pour ce faire, comme le montre la figure 2, le support 100 comporte des moyens d'appui réciproques 190 entre ledit corps 110 et ladite plaquette 150. Plus précisément, comme le montrent les figures 4 et 6, les moyens d'appui réciproques 190 comportent le trottoir d'appui 191 du corps 110 du support 100 et des moyens d'appui complémentaires 192 de la plaquette 150. Le trottoir d'appui 191 est ménagé dans le logement 140 et s'étend à partir de la face arrière 112B du cadre 112, tout le long des bords latéraux 140B opposés et du fond 140A du logement 140, vers l'intérieur dudit logement 140 (figure 4). Le trottoir d'appui 191 s'étend en dehors de la zone de coulissement, en particulier le long des bords latéraux 140B opposées où il s'étend entre lesdits bords latéraux 140B et les moyens de coulissement 130. Le trottoir d'appui 191 présente une largeur limitée de manière à maximiser la partie traversante du logement 140. Les moyens d'appui complémentaires 192 de la plaquette 150 sont quant à eux formés par une surface arrière de la plaquette 150 disposée en retrait par rapport à la face arrière 150B de ladite plaquette 150 et s'étendant le long des bords d'extrémité 150C et du bord interne 154 de ladite paquette 150 (figure 6). Ainsi, lorsque la plaquette 150 est assemblée sur le corps du support 100, les moyens d'appui complémentaires 192 prennent au moins partiellement appui sur le trottoir d'appui 191 du corps 110, et l'ouverture traversante 120 de la plaquette 150 est intégralement disposée en dehors du trottoir d'appui 191, à distance de ce dernier. Lorsque la vis de fixation 500 est vissée dans le fût de vissage 11, les moyens d'appui complémentaires 192 de la plaquette 150 sont appuyés contre le trottoir d'appui 191 du logement 140 (figure 9) et forcent la face arrière 112B du cadre 112 du corps 110 du support 100 à venir se plaquer contre la paroi dans laquelle est encastrée la boîte électrique 10.

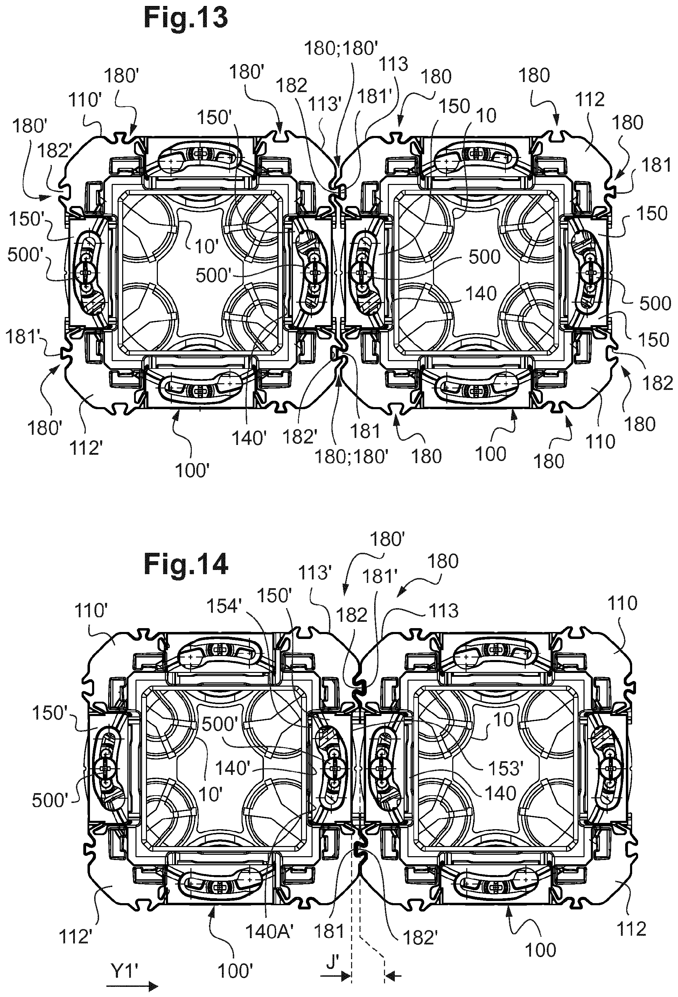

Par ailleurs, comme le montrent plus particulièrement les figures 13 et 14, le support 100 comporte sur chacune des branches de son cadre 112, des moyens de jumelage 180 à un autre support 100' du même type.

Avantageusement, les moyens de jumelage 180 permettent la solidarisation dudit support 100 (premier support 100) à un autre support 100' (deuxième support 100') du même type, de manière à former un seul support multiposte. Les dimensions hors-tout des premier et deuxième supports 100, 100' jumelés par les moyens de jumelage 180, 180' (figure 14) sont alors égales à celle d'un support multiposte formé d'un seul bloc.

Deux plaquettes 150 reçues mobiles en coulissement sur le corps 110 d'un des deux supports 100, 100', en vis-à-vis par rapport l'ouverture d'accueil 115, facilitent ce jumelage.

Comme le montre la figure 13, préférentiellement, les moyens de jumelage 180, 180' comprennent sur chaque branche du cadre 112, 112', le long du bord périphérique externe 113, 113', à l'extérieur du renfoncement, un élément mâle et un élément femelle. Lesdits moyens de jumelage 180, 180' viennent de formation avec le corps 110, 110' du support 100, 100'.

Plus particulièrement, les moyens de jumelage 180, 180' de chaque branche du cadre 112 comprennent, un ergot 181, 181' et une encoche 182, 182' de contours complémentaires, délimités par le bord périphérique externe 113, 113' du cadre 112,112'. L'ergot 181, 181' s'étend en saillie du cadre 112, 112' (élément mâle) tandis que l'encoche 182, 182' s'étend vers l'intérieur du cadre 112, 112' (élément femelle). L'ergot 181, 181' et l'encoche 182, 182' sont disposés de part et d'autre de l'entrée du logement 140,140'.

Comme le montrent les figures 13 et 14, l'ergot 181 disposé d'un côté du logement 140 du premier support 100 est destiné à s'accrocher dans l'encoche 182' prévue en correspondance sur le bord périphérique externe 113' du cadre 112' du deuxième support 100' adjacent, tandis que l'encoche 182 disposée de l'autre côté du logement 140 du premier support 100 est destinée à recevoir l'ergot 181' du deuxième support 100' adjacent.

Les moyens de jumelage 180, 180' sont identiques sur tous les côtés du cadre 112, 112', de sorte que les premier et deuxième supports 100, 100' peuvent être associés l'un à l'autre dans tous les sens, et associés à un ou plusieurs autres supports adjacents du même type. Même si on pivote le premier support 100 par rapport au deuxième support 100', les moyens de jumelage 180 du premier support 100 pivoté restent positionnés correctement par rapport aux moyens de jumelage 180' du deuxième support 100' qui n'a pas bougé, pour coopérer avec lui.

En pratique, pour jumeler les premier et deuxième supports 100, 100' entre eux, un utilisateur procède de la manière suivante : il monte et fixe le premier support 100 sur la première boîte électrique 10 de la manière décrite précédemment, puis il monte le deuxième support 100' sur la deuxième boîte électrique 10' adjacente à la première (figure 13).

Comme le montre la figure 13, après cette opération, les plaquettes 150, 150' des premier et deuxième supports 100, 100' recevant les vis de fixation 500, 500' sont toutes en première position de montage. En outre, le premier support 100 est entièrement fixe sur la première boîte électrique 10 tandis que seules les plaquettes 150' du deuxième support 100' sont fixes sur la deuxième boîte électrique 10', maintenues par les vis de fixation 500'. Un déplacement relatif des plaquettes 150' et du corps 110' du deuxième support 100', selon la direction de coulissement Y1', est encore permis puisque le deuxième support 100' est seulement monté et non fixé sur la deuxième boîte électrique 10'.

Lorsque les première et deuxième boîtes électriques 10,10' ont été encastrées dans la paroi de manière telle que les premier et deuxième supports 100, 100' ne peuvent pas être jumelés directement car ils sont trop loin l'un de l'autre (figure 13), il est encore possible d'emboîter les moyens de jumelage 180 du premier support 100 avec les moyens de jumelage 180' du deuxième support 100' en rapprochant le corps 110' du deuxième support 100' vers le corps 110 du premier support 100, selon la direction de coulissement Y1' (figure 14). Après ce rapprochement permettant de rattraper le petit décalage entre les boîtes électriques 10, 10', les positions relatives de chaque plaquette 150' du deuxième support 100' qui reçoivent lesdites vis de fixation 500' et du corps 110' du deuxième support 100' ont été modifiées.

Sur la figure 14, on peut voir que les plaquettes 150' adoptent respectivement la position de repos et une deuxième position de montage dans laquelle le bord interne 154' de la plaquette 150' est au contact du fond 140A' du logement 140' correspondant. Autrement dit, une des plaquettes 150' adopte la position extrême externe (position de repos), tandis que l'autre plaquette 150' adopte la position extrême interne (deuxième position de montage). Dans la deuxième position de montage, un jeu J' existe entre le bord externe 153' de la plaquette 150' et la portion du bord périphérique externe 113' s'étendant de part et d'autre du logement 140'.

Une fois les premier et deuxième supports 100, 100' jumelés grâce au rapprochement du corps 110' du deuxième support 100' vers celui du premier support 100, les vis de fixation 500' peuvent être vissées au maximum dans la deuxième boîte électrique 10'. Les premier et deuxième supports 100, 100' ainsi jumelés peuvent alors recevoir la plaque de finition 30 biposte normalement conditionnée pour habiller un support biposte (figure 12).

Lors du démontage du support 100 de la boîte électrique 10, les deux vis de fixation 500 sont desserrées, et les lames ressorts 161 repoussent les plaquettes 150 vers l'extérieur du support 100, en direction de leur position de repos respective. La forme et le positionnement « en retrait » du trottoir 123 délimitant le trou oblong 122, aidés de la force de poussée des lames ressort 161, facilitent le pivotement angulaire inverse du support 100 visant à ramener la tête des vis 501 en face des parties circulaires 121. L'invention permet donc en outre de faciliter le démontage et l'extraction du support 100.

Le support selon l'invention n'est nullement limité au mode de réalisation décrit ci-dessus et de nombreuses variantes peuvent être envisagées et combinées entre elles.

En particulier, il est envisageable de définir la position de repos de la plaquette sur le corps du support comme une position dans laquelle une partie de la tranche de ladite plaquette, orientée vers l'extérieur du support d'appareillage électrique (ici le bord externe de la tranche de la plaquette), s'étend globalement en retrait de la première partie du bord périphérique externe dudit cadre qui s'étend de part et d'autre du logement.

Notamment, il est envisageable de définir la position de repos de la plaquette sur le corps du support comme la position dans laquelle le bord interne de ladite plaquette s'étend contre le fond du logement formé par la deuxième portion du bord périphérique externe du cadre. Autrement dit, il est envisageable de définir la position de repos comme la position extrême interne de la plaquette dans son logement. Dans ce cas, le centre de chaque partie circulaire de l'ouverture traversante est décalé vers l'extérieur du grand axe du trou oblong, d'une distance égale à la moitié de la course totale de coulissement (et non vers l'intérieur comme ce qui a été décrit précédemment dans le premier mode de réalisation du support).

On peut encore prévoir que la position de repos de la plaquette sur le corps du support soit une position intermédiaire de la plaquette dans son logement, entre les positions extrêmes interne et externe décrites précédemment. La position de repos peut notamment correspondre à la position centrale de la plaquette dans son logement. Dans le cas où la position de repos de la plaquette est intermédiaire, les moyens de rappel élastique sont formés par une lame ressort bistable ramenant la plaquette dans sa position de repos lorsqu'elle est coulissée dans le logement vers l'intérieur ou l'extérieur du support. Le grand axe du trou oblong de l'ouverture traversante de la plaquette passe alors par le centre de la partie traversante.

On a représenté sur les figures 15 à 17, le support d'appareillage électrique 200 selon le deuxième mode de réalisation de l'invention. Comme le support 100 selon le premier mode de réalisation, le support 200 comporte une plaquette 250 mobile reçue dans un logement 240 d'un corps 210 du support 200. Ce support 200 est très semblable à celui décrit dans le premier mode de réalisation, à ceci près que des moyens de rappel élastique 260 intervenant entre la plaquette 250 et le corps 210 sont ici portés par la plaquette 250 et prennent appui sur une surface d'appui 255 du corps 210 dudit support 200.

Ces moyens de rappel élastique 260 viennent de formation avec ladite plaquette 250. Ils sont donc moulés en matière plastique, comme la plaquette 250. Leur propriété de « rappel » leur est notamment conférée par le matériau utilisé pour leur fabrication, leur forme, leur épaisseur et leur raideur.

Plus précisément, tel que cela est représenté sur les figures 15 et 16, à l'entrée du logement 240 et à proximité d'une face avant 212A d'un cadre 212 du corps 210, deux bords latéraux 240B opposés du logement 240 présentent un décroché 240C formant la surface d'appui 255 du corps 110. Chaque décroché 240C est destiné à recevoir une patte flexible 261 s'étendant à partir d'un bord d'extrémité 250C de la plaquette 250 et formant le moyen de rappel élastique 260. Chaque patte flexible 261 s'étend ici sur une portion avant de la plaquette 250, en direction d'un fond 240A du logement 240 et vers une ouverture d'accueil 215 du support 200.

Telle que représentée sur les figures 15 et 16, la plaquette 250 est en position de repos sur le corps 210 du support 200 et une extrémité libre 261A de chaque patte flexible 261 repose contre le surface d'appui 255.

Comme le montre la figure 17, lorsque la plaquette 250 est coulissée dans le logement 240 en dehors de sa position de repos, par exemple jusqu'à une première position de montage, l'extrémité libre 261A de chaque patte flexible 261 appuie sur la surface d'appui 255 correspondante du corps 210, ce qui fait ployer chaque patte flexible 261 et l'éloigne du bord d'extrémité 250C de la plaquette 250 à partir de laquelle elle s'étend. En position extrême interne (non représentée), le bord interne 261B de la patte flexible 261 de la plaquette 250 vient prendre appui contre la surface d'appui 255 du corps 210 du support 200. Dès qu'elles sont en dehors de leur position de repos, les pattes flexibles 261 cherchent à revenir vers leur position de repos en exerçant une force de poussée contre les surfaces d'appui 255. Ce faisant, elles ramènent la plaquette 250 vers sa position de repos.

Le reste du support 200 est en tout point identique à ce qui a été décrit pour le support 100 selon le premier mode de réalisation, si ce n'est que dans ce deuxième mode de réalisation, il n'y a pas de moyens de blocage pour empêcher le désassemblage involontaire de la plaquette 250 et du corps 210 du support 200.

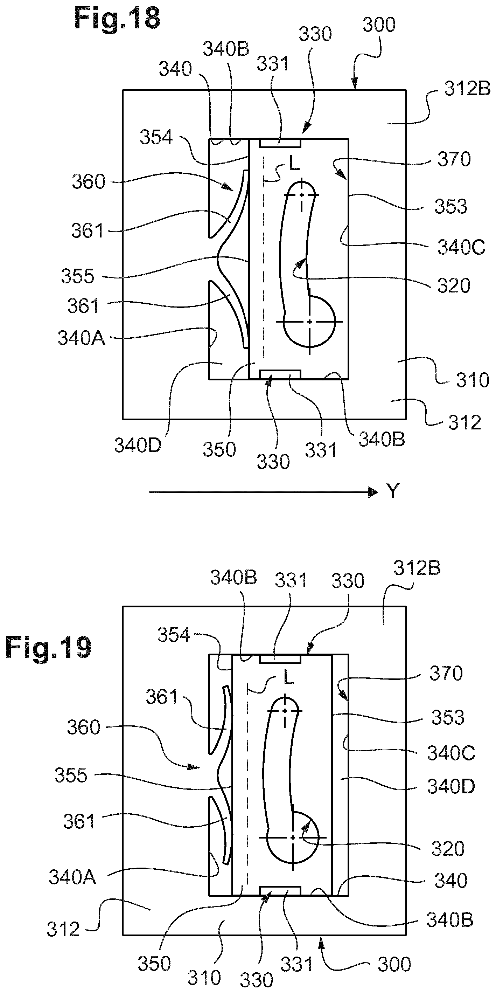

On a représenté sur les figures 18 et 19, un logement 340 d'un corps 310 du support d'appareillage électrique 300 selon le troisième mode de réalisation de l'invention. Comme le support 100 selon le premier mode de réalisation, le support 300 comporte une plaquette 350 mobile reçue dans le logement 340. Ce support 300 est très semblable à celui décrit dans le premier mode de réalisation, à ceci près que le logement 340 est formé, non pas par un renfoncement du bord périphérique externe du support 300, mais par un renfoncement prévu au sein même d'un cadre 312 du support 300, à distance des bords périphériques externe et interne du corps 310, et s'ouvre vers l'arrière du support 300.

Plus précisément, selon ce troisième mode de réalisation, quatre logements 340 sont ménagés en renfoncement dans une face arrière 312B du cadre 312 du corps 310, sur chaque branche du cadre 312, entre ledit bord périphérique externe et le bord périphérique interne du cadre formant une ouverture d'accueil d'un mécanisme d'appareillage électrique.

Chaque logement 340 de réception des plaquettes 350 est ainsi prévu en creux de la face arrière 312B du cadre 312 du corps 310 du support 300. Chaque logement 340 est fermé par quatre côtés formant quatre bords latéraux du logement 340, à savoir deux bords latéraux 340B opposés, perpendiculaires aux bords périphériques interne et externe de la branche correspondante du cadre 112, et deux bords latéraux 340A, 340C opposés, parallèles auxdits bords périphériques interne et externe de cette branche du cadre 312 du corps 310. L'entrée dans le logement 340 est délimitée entre ces quatre bords latéraux 340A, 340B, 340C, au niveau de la face arrière 312B du cadre 312. Le logement 340 est partiellement fermé par un fond 340D, à l'opposé de l'entrée (et non quasi-intégralement ouvert comme dans les premier et deuxième modes de réalisation). Le bord latéral 340C le plus proche dudit bord périphérique externe est dénommé dans la suite « bord latéral externe 340C » du logement 340, tandis que le bord latéral 340A le plus proche dudit bord périphérique interne est dénommé dans la suite « bord latéral interne 340A » du logement.

Il est prévu des moyens de coulissement 330 sous forme de deux pattes de coulissement 331 s'étendant de part et d'autre du logement 340. Chaque patte de coulissement 331 est portée par un des bords latéraux 340B opposés du logement 340. Ces pattes de coulissement 331 forment avec le fond 340D du logement 340 une coulisse pour la plaquette 350 et permettent de retenir la plaquette 350 de manière imperdable sur le support 300.

Ici, des moyens de rappel élastique 360 sont portés par le corps 310 du support 300 et sont formés en matériaux plastiques. Ils sont formés dans chaque logement 340 par deux pattes souples 361 s'étendant selon un « V » à partir d'un des bords latéral externe ou interne 340C, 340A du logement 340. Ici, les pattes souples 361 sont portées par le bord latéral interne 340A du logement 340.

La plaquette 350 est ici par exemple réalisée en matériau métallique, et présente une épaisseur relativement mince. Elle comporte une ouverture traversante 320 semblable à celle d'une plaquette 150 selon le premier mode de réalisation. La plaquette 350 est assemblée en force ou clippée de manière irréversible dans le logement 340 jusqu'à être maintenue entre les pattes de coulissement 331 et le fond 340D.

Une fois assemblée sur le corps 310, la plaquette 350 peut coulisser selon une direction de coulissement Y transverse du corps 310, s'étendant entre les bords périphériques interne et externe du corps, perpendiculairement à la direction longitudinale selon laquelle s'étend l'ouverture traversante 320.

Lorsque la plaquette 350 est en position de repos sur le corps 310 du support 300 (figure 18), un bord externe 353 de ladite plaquette 350, orientée vers l'extérieur du support 300, s'étend contre le bord latéral externe 340C du logement 340. Les pattes souples 361 sont alors en appui sur un bord interne 354 de la plaquette 350, orienté vers l'intérieur du support 300 (vers l'ouverture d'accueil du mécanisme d'appareillage électrique). Ce bord interne 354 de la plaquette 350 forme ainsi la surface d'appui 355 de la plaquette 350.

Lorsque la plaquette 350 est en première position de montage sur le corps 310, (figure 19), ici centrale, le bord externe 353 de la plaquette 350 s'étend à distance du bord latéral externe 340C, du logement 340. Les pattes souples 361 sont comprimées vers le bord latéral interne 340A du logement 340 à partir de laquelle elles s'étendent. Ces pattes souples 361 ont naturellement tendance à reprendre leur position de repos, et donc à repousser la plaquette 350 en position de repos.

Selon ce troisième mode de réalisation, des moyens de blocage 370 sont formés par le bord latéral externe 340C du logement 340, contre laquelle la plaquette 350 vient prendre appui lorsque les moyens de rappel élastiques 360 la repousse en position de repos.

Selon une autre variante, non représentée, il est aussi envisageable de prévoir qu'une seule des plaquettes soit mobile en coulissement dans son logement, les moyens de rappel élastique étant alors prévus entre le corps du support et cette plaquette seulement. Les autres ouvertures traversantes sont dans ce cas prévues directement dans la branche du cadre correspondante, cette branche ne comportant alors pas de découpe formant de logement, ou sont portées par d'autres plaquettes rapportées de manière fixe sur le support. Cette variante facilite le montage du support sur la boîte électrique car les moyens de rappel élastique rappelant la plaquette en position de repos permettent de conserver le bon entraxe entre l'ouverture traversante de cette plaquette et l'ouverture traversante du support située en vis-à-vis par rapport à l'ouverture d'accueil du mécanisme d'appareillage électrique pour monter le support sur la boîte électrique, tandis que les moyens de coulissement permettent de conserver un degré de liberté pour déplacer la plaquette en cas de besoin.

On peut aussi envisager que l'ouverture traversante de chaque plaquette soit formée d'un simple trou oblong, dont le grand axe est parallèle à la branche du cadre dans laquelle elle s'étend. Dans ce cas, pour monter le support sur la boîte électrique, les vis sont d'abord positionnées dans les trous oblongs du support, puis l'ensemble est rapporté sur la boîte électrique. Le montage du support sur la boîte électrique reste facilité puisque les axes des vis reçues dans les plaquettes en position de repos sur le corps du support sont automatiquement distants de l'entraxe séparant les fûts de vissage des vis prévus sur la boîte électrique.

On peut aussi envisager que le cadre du corps du support présente une forme globalement circulaire. Dans ce cas, la direction de coulissement transverse de la plaquette sur le corps du support est radiale par rapport audit cadre.

L'invention peut aussi s'appliquer à un support multiposte d'un seul bloc adapté à recevoir plusieurs mécanismes d'appareillage électrique via plusieurs ouvertures d'accueil, et à être fixé sur une boîte électrique multiposte. Un tel support multiposte ne comporte généralement pas d'ouverture traversante pour le passage des vis de fixation entre les ouvertures d'accueil de réception des mécanismes d'appareillage électrique, mais seulement à la périphérie, le long du bord périphérique externe du corps. Un tel support multiposte peut être jumelé à un autre support multiposte ou monoposte comme expliqué précédemment.

## Revendications

1. Support d'appareillage électrique (100 ; 200 ; 300) comportant un corps (110 ; 210 ; 310) et au moins une plaquette (150 ; 250 ; 350) mobile munie d'une ouverture traversante (120 ; 320) pour la fixation dudit support d'appareillage électrique (100 ; 200 ; 300) sur un élément de réception (10), ladite ouverture traversante (120 ; 320) de la plaquette (150 ; 250 ; 350) étant de forme globalement allongée selon une direction longitudinale (L) pour le passage d'un élément de fixation (500) destiné à fixer ledit support d'appareillage électrique (100 ; 200 ; 300) à l'élément de réception (10),
le corps (110 ; 210 ; 310) comprenant au moins un logement(140 ; 240 ; 340) accueillant ladite plaquette (150 ; 250 ; 350) mobile,
**caractérisé en ce que** le corps (110 ; 210 ; 310) est pourvu de moyens de coulissement (130 ; 330) ménagés dans chaque logement (140 ; 240 ; 340),
**en ce que** chaque plaquette (150 ; 250 ; 350) est reçue par lesdits moyens de coulissement (130 ; 330), lesdits moyens de coulissement (130 ; 330) autorisant le coulissement de la plaquette (150 ; 250 ; 350) montée à l'intérieur du logement (140 ; 240 ; 340) selon une direction de coulissement (Y1, Y2, Y) globalement perpendiculaire à ladite direction longitudinale (L), et
**en ce que** ledit support d'appareillage électrique (100 ; 200 ; 300) comprend en outre des moyens de rappel élastique (160 ; 260 ; 360) intervenant entre la plaquette (150 ; 250 ; 350) et le corps (110 ; 210 ; 310) pour rappeler ladite plaquette (150 ; 250 ; 350) dans une position de repos prédéterminée.

2. Support d'appareillage électrique (100 ; 300) selon la revendication 1, dans lequel lesdits moyens de rappel élastique (160 ; 360) sont portés par le corps (110 ; 310) dudit support d'appareillage électrique (100 ; 300) et prennent appui sur une surface d'appui (155 ; 355) de ladite plaquette (100 ; 300).

3. Support d'appareillage électrique (200) selon la revendication 1, dans lequel lesdits moyens de rappel élastique (260) sont portés par ladite plaquette (250) et prennentappui sur une surface d'appui (255) du corps (210) dudit support d'appareillage électrique (200).

4. Support d'appareillage électrique (100 ; 200) selon l'une des revendications 1 à 3, dans lequel ledit corps (110 ; 210) comporte un cadre (112 ; 212) dont le bord périphérique externe (113) délimite, par renfoncement, le logement (140 ; 240) de sorte que ledit logement (140 ; 240) s'ouvre vers l'extérieur du support d'appareillage électrique (100 ; 200).

5. Support d'appareillage électrique (100 ; 200) selon la revendication 4, dans lequel, dans ladite position de repos, une partie (153 ; 253) de la tranche de ladite plaquette (150 ; 250), orientée vers l'extérieur du support d'appareillage électrique (100 ; 200), s'étend globalement dans l'alignement d'une partie (113A) du bord périphérique externe (113) dudit cadre (112 ; 212) qui s'étend de part et d'autre du logement (140 ; 240).

6. Support d'appareillage électrique selon la revendication 4, dans lequel, dans ladite position de repos, une partie de la tranche de ladite plaquette, orientée vers l'extérieur du support d'appareillage électrique, s'étend globalement en retrait d'une partie du bord périphérique externe dudit cadre qui s'étend de part et d'autre du logement.

7. Support d'appareillage électrique (300) selon l'une des revendications 1 à 6, dans lequel, ledit corps (310) comporte un cadre (312) présentant un bord périphérique externe et un bord périphérique interne reliés entre eux par une face arrière (312B), et le logement (340) est ménagé en renfoncement de ladite face arrière (312B), à distance desdits bords périphériques externe et interne dudit cadre (312), de sorte que le logement(340) s'ouvre vers l'arrière du support d'appareillage électrique (300).

8. Support d'appareillage électrique (100 ; 300) selon l'une des revendications 1 à 7, dans lequel il est en outre prévu des moyens de blocage (170 ; 370) opposés auxdits moyens de rappel élastique (160 ; 360) selon la direction de coulissement (Y1, Y2, Y), pour maintenir la plaquette (150 ; 350) sur ledit corps (110 ; 310) du support d'appareillage électrique (100 ; 300).

9. Support d'appareillage électrique (100 ; 200 ; 300) selon l'une des revendications 1 à 8, dans lequel le corps (110 ; 210 ; 310) comporte deux logements (140 ; 240 ; 340) alignés accueillant en coulissement deux plaquettes, et dans lequel il est prévu des moyens de rappel élastique (160 ; 260 ; 360) intervenant entre chaque plaquette (150 ; 250 ; 350) et ledit corps (110 ; 210 ; 310) pour rappeler chaque plaquette (150 ; 250 ; 350) dans une position de repos prédéterminée.

10. Support d'appareillage électrique (100 ; 200 ; 300) selon la revendication 9, dans lequel, ladite ouverture traversante (120 ; 320) de chaque plaquette (150 ; 250 ; 350) étant en forme de trou de serrure avec une partie circulaire (121) pour le passage de la tête (501) d'un élément de fixation (500), les positions de repos des deux plaquettes (150 ; 250 ; 350) sont définies comme les positions dans lesquelles les centres (C) des parties circulaires (121) desdites ouvertures traversantes (120 ; 320) sont distants l'un de l'autre d'une distance prédéterminée égale à l'entraxe (D) séparant deux fûts de réception (11) des éléments de fixation (500) dans l'élément de réception (10).

11. Support d'appareillage électrique (100; 200 ; 300) selon la revendication 10, dans lequel l'ouverture traversante (120 ; 320) de chaque plaquette (150 ; 250 ; 350) comporte en outre une partie oblongue (122) prolongeant ladite partie circulaire (121) qui présente une largeur inférieure au diamètre de ladite partie circulaire (121), et dont le grand axe (E) est décalé du centre (C) de ladite partie circulaire (121) d'une distance inférieure ou égale à la course totale de coulissementde la plaquette (150 ; 250 ; 350) dans son logement (140 ; 240 ; 340).

12. Appareillage électrique (1) comportant un support d'appareillage électrique (100 ; 200 ; 300) selon l'une des revendications précédentes, et un mécanisme d'appareillage électrique (20) monté sur ledit support d'appareillage électrique (100 ; 200 ; 300).

## Patentansprüche

1. Halterung für elektrische Geräte (100; 200; 300) mit einem Körper (110; 210; 310) und mindestens einem mit einer Durchgangsöffnung (120; 320) für die Befestigung der Halterung für elektrische Geräte (100; 200; 300) auf einem Aufnahmeelement (10) versehenen bewegbaren Plättchen (150; 250; 350), wobei die Durchgangsöffnung (120; 320) des Plättchens (150; 250; 350) von im Wesentlichen länglicher Form in einer Längsrichtung (L) für das Hindurchführen eines für die Befestigung der Halterung für elektrische Geräte (100; 200; 300) am Aufnahmeelement (10) bestimmten Befestigungselements (500) ist,
wobei der Körper (110; 210; 310) mindestens eine das bewegbare Plättchen (150; 250; 350) aufnehmende Aufnahme (140; 240; 340) aufweist,
**dadurch gekennzeichnet, daß** der Körper (110; 210; 310) mit in jeder Aufnahme (140; 240; 340) eingerichteten Gleitmitteln (130; 330) versehen ist,
daß jedes Plättchen (150; 250; 350) von den Gleitmitteln (130; 330) aufgenommen wird, wobei die Gleitmittel (130; 330) das Gleiten des im Inneren der Aufnahme (140; 240; 340) angeordneten Plättchens (150; 250; 350) in einer im Wesentlichen zur Längsrichtung (L) senkrechten Gleitrichtung (Y1, Y2, Y) ermöglichen, und
daß die Halterung für elektrische Geräte (100; 200; 300) außerdem zwischen dem Plättchen (150; 250; 350) und dem Körper (110; 210; 310) eingreifende elastische Rückstellmittel (160; 260; 360) aufweist, um das Plättchen (150; 250; 350) in eine vorbestimmte Ruheposition zurückzustellen.

2. Halterung für elektrische Geräte (100; 300) gemäß Anspruch 1, bei der die elastischen Rückstellmittel (160; 360) vom Körper (110; 310) der Halterung für elektrische Geräte (100; 300) getragen werden und auf einer Auflagefläche (155; 355) des Plättchens (100; 300) aufliegen.

3. Halterung für elektrische Geräte (200) gemäß Anspruch 1, bei der die elastischen Rückstellmittel (260) vom Plättchen (250) getragen werden und auf einer Auflagefläche (255) des Körpers (210) der Halterung für elektrische Geräte (200) aufliegen.

4. Halterung für elektrische Geräte (100; 200) gemäß einem der Ansprüche 1 bis 3, bei der der Körper (110; 210) einen Rahmen (112; 212) aufweist, dessen äußerer umlaufender Rand (113) durch Vertiefung die Aufnahme (140; 240) umgrenzt, so daß sich die besagte Aufnahme (140; 240) nach außerhalb der Halterung für elektrische Geräte (100; 200) öffnet.

5. Halterung für elektrische Geräte (100; 200) gemäß Anspruch 4, bei der sich in der Ruheposition ein nach außerhalb der Halterung für elektrische Geräte gerichteter Teil (153; 253) der Seitenfläche des Plättchens (150; 250) im Wesentlichen in einer Linie mit einem Teil (113A) des äußeren umlaufenden Rands (113) des Rahmens (112; 212) erstreckt, der sich beiderseits der Aufnahme (140; 240) erstreckt.

6. Halterung für elektrische Geräte gemäß Anspruch 4, bei der sich ein nach außerhalb der Halterung für elektrische Geräte gerichteter Teil der Seitenfläche des Plättchens im Wesentlichen gegenüber einem Teil des äußeren umlaufenden Rands des Rahmens, der sich beiderseits der Aufnahme erstreckt, zurückgesetzt erstreckt.

7. Halterung für elektrische Geräte (300) gemäß einem der Ansprüche 1 bis 6, bei der der Körper (310) einen Rahmen (312) mit einem umlaufenden äußeren Rand und einem umlaufenden inneren Rand, die beide durch eine Rückseite (312B) miteinander verbunden sind, aufweist und die Aufnahme (340) in einem Abstand vom umlaufenden äußeren und umlaufenden inneren Rand des Rahmens (312) als Vertiefung der Rückseite (312B) ausgebildet ist, so daß die Aufnahme (340) zur Rückseite der Halterung für elektrische Geräte (300) hin offen ist.

8. Halterung für elektrische Geräte (100; 300) gemäß einem der Ansprüche 1 bis 7, bei der außerdem den elastischen Rückstellmitteln (160; 360) in der Gleitrichtung (Y1, Y2, Y) entgegengesetzte Blockiermittel (170; 370) vorgesehen sind, um das Plättchen (150; 350) auf dem Körper (110; 310) der Halterung für elektrische Geräte (100; 300) zu halten.

9. Halterung für elektrische Geräte (100; 200; 300) gemäß einem der Ansprüche 1 bis 8, bei der der Körper (110; 210; 310) zwei aufeinander ausgerichtete Aufnahmen (140; 240; 340) aufweist, die zwei Plättchen gleitend aufnehmen, und bei der zwischen jedem Plättchen (150; 250; 350) und dem Körper (110; 210; 310) eingreifende elastische Rückstellmittel (160; 260; 360) vorgesehen sind, um jedes Plättchen (150; 250; 350) in eine vorbestimmte Ruheposition zurückzustellen.

10. Halterung für elektrische Geräte (100; 200; 300) gemäß Anspruch 9, bei der die Durchgangsöffnung (120; 320) jedes Plättchens (150; 250; 350) die Form eines Schlüssellochs mit einem kreisförmigen Teil (121) für das Hindurchführen des Kopfs (501) eines Befestigungselements (500) hat, wobei die Ruhepositionen der beiden Plättchen (150; 250; 350) als die Positionen definiert sind, in denen die Mittelpunkte (C) der kreisförmigen Teile (121) der Durchgangsöffnungen (120; 320) in einem vorbestimmten Abstand voneinander sind, der gleich dem Achsabstand (D) zweier Aufnahmeschächte (11) der Befestigungselemente (500) im Aufnahmeelement (10) ist.

11. Halterung für elektrische Geräte (100; 200; 300) gemäß Anspruch 10, bei der die Durchgangsöffnung (120; 320) jedes Plättchens (150; 250; 350) außerdem einen den kreisförmigen Teil (121) verlängernden länglichen Teil (122) aufweist, der eine Breite aufweist, die geringer als der Durchmesser des kreisförmigen Teils (121) ist, und dessen Hauptachse (E) gegenüber dem Mittelpunkt (C) des kreisförmigen Teils (121) um einen Abstand versetzt ist, der kleiner als oder gleich der gesamten Gleitstrecke des Plättchens (150; 250; 350) in dessen Aufnahme (140; 240; 340) ist.

12. Elektrisches Gerät (1) mit einer Halterung für elektrische Geräte (100; 200; 300) gemäß einem der vorangehenden Ansprüche und einem an der Halterung für elektrische Geräte (100; 200; 300) befestigten elektrischen Gerätemechanismus (20).

## Claims

1. Electrical equipment support (100; 200; 300) comprising a body (110; 210; 310) and at least one movable plate (150; 250; 350) provided with a through opening (120; 320) for fixing said electrical equipment support (100; 200; 300) to a receiving element (10), said through opening (120; 320) of the plate (150; 250; 350) being generally elongated in a longitudinal direction (L) for the passage of a fixing element (500) intended to fix said electrical equipment support (100; 200; 300) to the receiving element (10),
the body (110; 210; 310) comprising at least one housing (140; 240; 340) receiving said movable plate (150; 250; 350),
**characterised in that** the body (110; 210; 310) is provided with sliding means (130; 330) provided in each housing (140; 240; 340),
**in that** each plate (150; 250; 350) is received by said sliding means (130; 330), said sliding means (130; 330) allowing the plate (150; 250; 350) mounted inside the housing (140; 240; 340) to slide in a sliding direction (Y1, Y2, Y) generally perpendicular to said longitudinal direction (L), and
**in that** said electrical equipment support (100; 200; 300) further comprises elastic return means (160; 260; 360) acting between the plate (150; 250; 350) and the body (110; 210; 310) to return said plate (150; 250; 350) to a predetermined rest position.

2. Electrical equipment support (100; 300) according to claim 1, wherein said elastic return means (160; 360) are carried by the body (110; 310) of said electrical equipment support (100; 300) and bear on a bearing surface (155; 355) of said plate (100; 300).

3. Electrical equipment support (200) according to claim 1, wherein said elastic return means (260) are carried by said plate (250) and bear on a bearing surface (255) of the body (210) of said electrical equipment support (200).

4. Electrical equipment support (100; 200) according to any one of claims 1 to 3, wherein said body (110; 210) comprises a frame (112; 212) the outer peripheral edge (113) of which delimits, by recessing, the housing (140; 240) so that said housing (140; 240) opens outwards from the electrical equipment support (100; 200).

5. Electrical equipment support (100; 200) according to claim 4, wherein, in said rest position, a portion (153; 253) of the edge of said plate (150; 250), facing outwards from the electrical equipment support (100; 200), extends generally in alignment with a portion (113A) of the outer peripheral edge (113) of said frame (112; 212) that extends on either side of the housing (140; 240).

6. Electrical equipment support according to claim 4, wherein, in said rest position, a portion of the edge of said plate, facing outwards from the electrical equipment support, extends generally retracted from a portion of the outer peripheral edge of said frame that extends on either side of the housing.

7. Electrical equipment support (300) according to any one of claims 1 to 6, wherein said body (310) comprises a frame (312) having an outer peripheral edge and an inner peripheral edge connected together by a rear face (312B), and the housing (340) is recessed from said rear face (312B), at a distance from said outer and inner peripheral edges of said frame (312), such that the housing (340) opens towards the rear of the electrical equipment support (300).

8. Electrical equipment support (100; 300) according to any one of claims 1 to 7, wherein locking means (170; 370) are further provided opposite said elastic return means (160; 360) in the sliding direction (Y1, Y2, Y), for holding the plate (150; 350) on said body (110; 310) of the electrical equipment support (100; 300).

9. Electrical equipment support (100; 200; 300) according to any one of claims 1 to 8, wherein the body (110; 210; 310) comprises two aligned housings (140; 240; 340) slidably accommodating two plates, and wherein elastic return means (160; 260; 360) are provided acting between each plate (150; 250; 350) and said body (110; 210; 310) to return each plate (150; 250; 350) to a predetermined rest position.

10. Electrical equipment support (100; 200; 300) according to claim 9, wherein said through opening (120; 320) of each plate (150; 250; 350) being in the form of a keyhole with a circular portion (121) for the passage of the head (501) of a fixing element (500), the rest positions of the two plates (150; 250; 350) are defined as the positions in which the centres (C) of the circular portions (121) of said through openings (120; 320) are distant from each other by a predetermined distance equal to the distance (D) separating two receiving barrels (11) of the fixing elements (500) in the receiving element (10).

11. Electrical equipment support (100; 200; 300) according to claim 10, wherein the through opening (120; 320) of each plate (150; 250; 350) further comprises an oblong portion (122) extending said circular portion (121) which has a width less than the diameter of said circular portion (121), and the major axis (E) of which is offset from the centre (C) of said circular portion (121) by a distance less than or equal to the total sliding stroke of the plate (150; 250; 350) in its housing (140; 240; 340).

12. Electrical equipment (1) comprising an electrical equipment support (100; 200; 300) according to any one of the preceding claims, and an electrical equipment mechanism (20) mounted on said electrical equipment support (100; 200; 300).
